# EUROPÄISCHE PATENTSCHRIFT

(11) **EP 0 614 580 B1**
(45) Veröffentlichungstag und Bekanntmachung des Hinweises auf die Patenterteilung: **05.03.1997**
(21) Anmeldenummer: 93919141.7
(22) Anmeldetag: 24.08.1993
(51) Int. Cl.: H02M 7/00, H02M 7/48

(54) **AUFBAU EINES WECHSELRICHTERS, INSBESONDERE EINES 3-PUNKTWECHSELRICHTERS**
STRUCTURE OF AN INVERTER, ESPECIALLY A 3-POINT INVERTER
STRUCTURE D'UN ONDULEUR, EN PARTICULIER UN ONDULEUR A TROIS POINTS

(30) Priorität: 25.09.1992 DE 4232763
(43) Veröffentlichungstag der Anmeldung: 14.09.1994
(73) Patentinhaber: AEG WESTINGHOUSE TRANSPORT-SYSTEME GmbH, D-13599 Berlin (DE)
(72) Erfinder: FREUDENTHALER, Kurt, D-12167 Berlin (DE); MUES, Michael, D-13595 Berlin (DE); SCHÜTZE, Thomas, D-10961 Berlin (DE); SETIAWAN, Hardono, D-13403 Berlin (DE)
(74) Vertreter: Hamilton, Eberhard
(86) Internationale Anmeldenummer: EP9302257
(87) Internationale Veröffentlichungsnummer: WO9408387

(56) Entgegenhaltungen:
- US-A- 4 458 305
- US-A- 5 172 310
- R. BAYERER: "Modultechnik für hohe Frequenzen in der Leistungselektronik" in ETG-Fachbericht 39 zur Tagung am 13./14. Mai 1992 in Bad Nauheim, Seiten 149-150.

## Beschreibung

Die Erfindung betrifft den Aufbau eines Wechselrichters, insbesondere eines 3-Punktwechselrichters, wie er im übrigen im Oberbegriff des Anspruches 1 näher definiert ist.

Eine derartige Anordnung ist z.B. für herkömmliche 2-Punkt-Wechselrichter aus der US-PS 4 458 305 bekannt. Mehrfach vorhandene Cu-Einzelsschienen aus Flachbandmaterial finden als GleichstromEingangs- und Wechselstrom-Ausgangsschienen Anwendung und kreuzen sich in definierten Abständen, wobei die Gleichstrom-Eingangsschienen flach auf dem Kühlkörper aufliegen und die Wechselstrom-Ausgangsschienen über Verbindungs-elemente zu den Schaltungselementen hochkant gehalten sind. Die Halbleiterventile und weiteren Schaltungselemente stehen über solche Verbindungselemente (Winkel oder Litzen) mit den Ein- und Ausgangsschienen in Verbindung. Der Austausch verlöteter Schaltungselemente ist problematisch und kostenintensiv. Durch die zahlreichen in Abstand befindlichen Einzelschienen kann eine solche Anordnung nicht sehr kompakt gehalten werden.

Antriebsstromrichteranlagen für Drehstromantriebe finden Anwendung in Industrie- und Verkehrsbereichen und werden zunehmend mit Pulswechselrichtern in IGBT-Technik ausgeführt, bei der wegen der beim Schalten der Halbleiterventile auftretenden Überspannungen bei Netzspannungen über 500 V eine Reihenschaltung der Halbleiter in den Brückenzweigen notwendig ist.

Wegen der Möglichkeit unsymmetrischer Spannungsaufteilung zwischen in Serie geschalteten Ventilen ist dies bei herkömmlichen 2-Punktwechselrichtern problematisch. Bei 3-Punktwechselrichtern wird eine symmetrische Spannungsaufteilung durch zwei Netzkondensatoren erzwungen.

Ein weiterer Grund für eine Entscheidung zum 3-Punktwechselrichter ist, daß wegen der sehr günstigen Oberschwingungseigenschaften der 3-Punkt-Schaltung bei der Auslegung von Stromrichtern im mittleren Leistungsbereich auch keine Kompromisse mehr zwischen Schaltfrequenz und Oberschwingungsstromgehalt notwendig werden.

Problematisch ist allerdings das schnelle Schalten der IGBT-Halbleiter, durch das, bedingt durch Streuinduktivitäten der Zuleitungen zu den IGBTs Überspannungen verursacht werden. Zum Schutz der Halbleiter können diese parasitären Induktivitäten durch kurze Leitungsführung und geeignete Leitungsgeometrie, z.B. durch Flachbandleitungen, reduziert werden (vgl. z.B. Aufsatz von R. Bayerer "Modultechnik für hohe Frequenzen in der Leistungselektronik", veröffentlicht in ETG-Fachbericht 39 zur Tagung 13./14. Mai 92 in Bad Nauheim, S. 149/150).

Eine weitere Möglichkeit induktivitätsarmer Verbindungstechnik bietet der Einsatz der sogenannten Multilayer-Technik. Hierbei werden zur Verbindung der Bauelemente im allgemeinen mehrlagige isolierte Leiterplatten oder -schienen eingesetzt, die aktive oder passive Bauelemente, z.B. IGBT-Module abdecken und in geeigneter Weise kontaktieren (vgl. a.a.O. Aufsatz von Salama/Tadros, S. 285/286 "IGBT-Wechselrichter für Antriebe in Industrie und Verkehr"). Die weiteren Bauelemente, wie Dioden, Kondensatoren und evtl. auch Beschaltungselemente sind auf der Multilayer-Platte angeordnet und dort mit den entsprechenden Leiterschichten verbunden.

Ein ähnlicher Aufbau für eine IGBT-Brücke ist der Mitsubishi-Druckschrift "IGBT-Modules (E-Series)" vom 24.1.92, Blatt C 7901-2A entnehmbar.

Diesen Aufbauten wiederum ist gemeinsam, daß im allgemeinen ein freier Zugang, zumindest zu den Leistungshalbleitern, nicht besteht und für bestimmte Arbeiten erst umständlich die abdeckende Mehrlagen-Leiterplatte gelöst und entfernt werden muß.

Aufgabe der Erfindung ist es, einen Aufbau für eine Antriebsstromrichteranlage, insbesondere mit 3-Punktwechselrichter, anzugeben, der eine besonders vorteilhafte und kompakte Bauweise erlaubt sowie geringen Montageaufwand, durch einfachen Zugang zu den Komponenten und auch durch das Entfallen bisher nötiger Beschaltungsmittel, benötigt.

Diese Aufgabe wird gemäß den kennzeichnenden Merkmalen des Anspruches 1 gelöst. Vorteilhafte Ausgestaltungen sind den Unteransprüchen entnehmbar.

Anhand von in der Zeichnung dargestellten schematischen Ausführungsbeispielen wird die Erfindung im nachstehenden näher erläutert.

Es zeigen:
- Fig. 1: den prinzipiellen mechanischen Aufbau des Wechselrichters
- Fig. 2: den prinzipiellen Aufbau mit mehr Einzelheiten zu den Mehrlagen-Verbindungsschienen und zur Kontaktierung der Bauelemente
- Fig. 3: das grundsätzliche Schaltschema eines Antriebsstromrichters mit beigeschaltetem Bremssteller

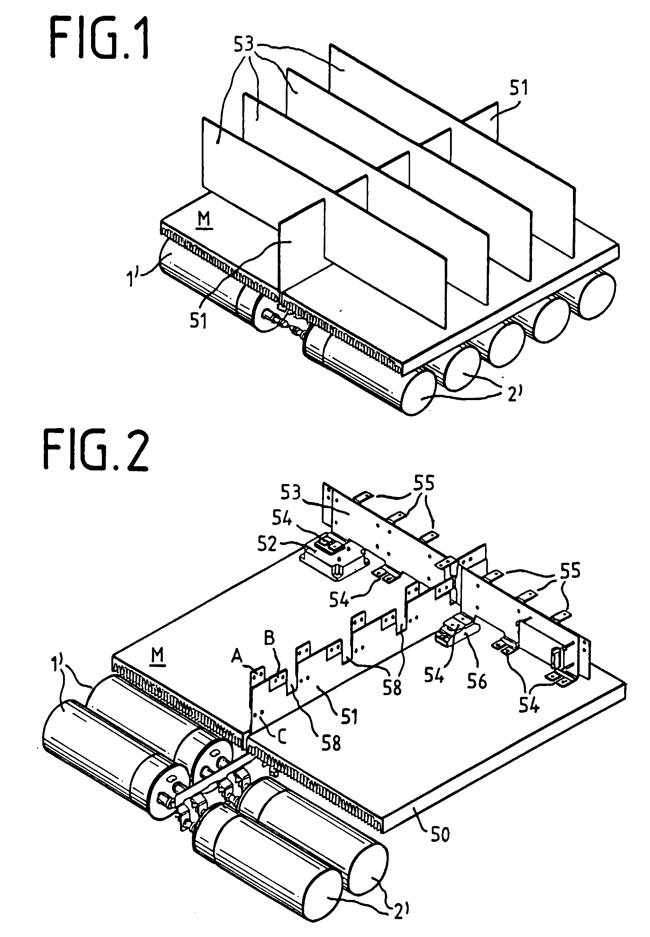

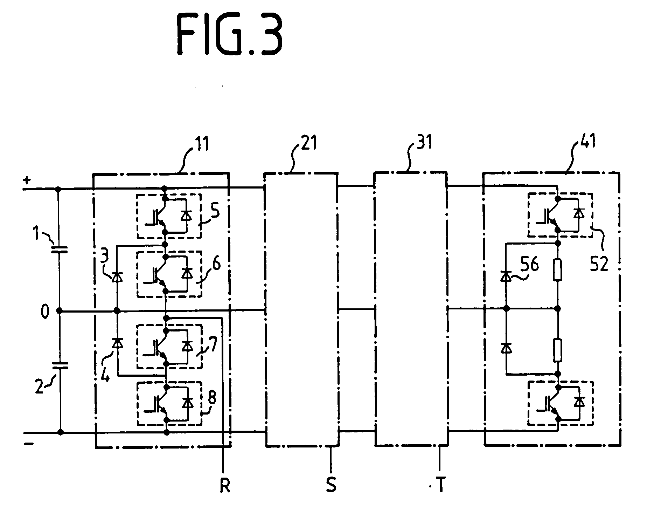

Die Fig. 3 zeigt eine an sich bekannte Schaltungsanordnung für einen Antriebsstromrichter für Triebfahrzeuge, ausgestattet mit einem 3-Punktwechselrichter und einem nachgeschalteten Bremssteller. Darin sind mit 1 und 2 zwei reihengeschaltete spannungsführende Netzkondensatoren bezeichnet. Sie bestehen real (vgl. Fig. 1 und 2) jeweils aus Gruppen von Einzelkondensatoren und sind an eine Gleichspannungsquelle (+, -) angeschlossen. Am Spannungsteilerpunkt 0 wird das 0-Volt-Potential abgegriffen. An diesen drei Potentialen +, 0, - liegen die Wechselrichterzweigpaare 11, 21, 31 sowie der Bremssteller 41 an. Die Wechselrichter-Zweigpaare weisen reihengeschaltete IGBT-Module 5, 6 und 7, 8 sowie Mittelpunktdioden 3, 4 auf. Die Anordnung bei den Zweigpaaren 21 und 31 ist gleichartig und deshalb nicht näher dargestellt. Die Lastabgänge sind mit R. S. T bezeichnet.

Die Fig. 1 und 2 zeigen für eine solche Schaltungsanordnung der Fig. 3 schematisch den räumlichen Aufbau.

Die Netzkondensatoren 1, 2 sind hier zu Gruppen 1' und 2' von Einzelkondensatoren unterhalb mehrerer Kühlkörper 50 angeordnet und dort elektrisch mit einer niederinduktiven Mehrlagen-Hauptverbindungsschiene 51 verbunden, die zwischen den Kühlkörpern 50 angeordnet ist. An dieser Hauptverbindungsschiene 51 liegt eine Gleichspannungsquelle mit den Potentialen + und - sowie das 0-Potential an. Die Mehrlagen-Hauptverbindungsschiene 51 ist in Hochkantstellung angeordnet und überragt die in der oberen Montageebene M montierten IGBT-Module, von denen in Fig. 2 nur ein IGBT-Modul 52 angedeutet ist. Rechtwinklig zur Mehrlagen-Hauptverbindungsschiene 51 und an diese elektrisch angeschlossen verlaufen mehrere entsprechend ausgebildete Mehrlagen-Verbindungsschienen, die als Mehrlagen-Nebenverbindungsschienen 53 bezeichnet werden. Diese dienen dem elektrischen Anschluß der IGBT-Module sowie der sonstigen benötigten Bauelemente wie Dioden (z.B. 3, 4, 56), Widerstände und Kondensatoren im Wechselrichter. Der elektrische Anschluß erfolgt durch Verschraubung über Laschen 54, 55. Weitere solcher Mehrlagen-Nebenverbindungsschienen 53 sind in der Fig. 1 angedeutet. Der elektrische Eigenanschluß der Mehrlagen-Nebenverbindungsschienen erfolgt über abgewinkelte Anschlußlaschen an Anschlußstellen A, B, C gemäß Fig. 2. Die Bereiche, in denen die Mehrlagen-Nebenverbindungsschienen 53 die Mehrlagen-Hauptverbindungsschiene 51 kreuzen, sind durch Aussparungen 58 freigemacht.

Aus Fig. 1 sind vier solcher Mehrlagen-Nebenverbindungsschienen ersichtlich. Drei sind für die drei Phasen des Wechselrichters und die verbleibende für den Mitanschluß des vorerwähnten Bremsstellers vorgesehen. Überall kann derselbe Verbindungsschienentyp eingesetzt werden. Die genannten Mehrlagenverbindungsschienen stellen alle elektrischen Verbindungen zwischen den aktiven und passiven Bauelementen her. Der erfindungsgemäße Aufbau und insbesondere die vertikale Anordnung der Mehrlagenverbindungsschienen gestattet eine leichte Zugänglichkeit für einen problemlosen Austausch der IBGT-Module und Mittelpunktdioden direkt von oben ohne weitere Bauelemente vorher lösen zu müssen. Weitere Vorteile bestehen darin, daß der Aufbau trotz der relativ hohen Anzahl von Halbleitern im Stromrichter sehr kompakt mit baugleichen Bauteilen und einer günstigen niederinduktiven Verschienung erfolgen kann, wodurch sich eine geringere Überspannungsbelastung, verbunden mit einem weitgehenden Verzicht auf Beschaltungslemente und höherer Ausnutzung der Leistungshalbleiter ergibt. Verdrahtungsarbeiten innerhalb der einzelnen Wechselrichter-Zweigpaare bzw. im Bremssteller entfallen völlig.

## Patentansprüche

1. Aufbau eines Wechselrichters, insbesondere eines 3-Punkt-Wechselrichters,bei dem die erforderlichen Halbleiterventile und weiteren Schaltungselemente auf Kühlkörpern untergebracht sind und mit mehreren sich kreuzenden Verbindungsschienen ein in elektrischer und mechanischer Sicht gleichartigen Aufbau unter einer fächerartigen Aufteilung erzielbar ist, in der die Halbleiterventile und weiteren Schaltungselemente des Wechselrichters phasenweise zusammengefaßt an die Verbindungsschienen anschließbar sind,
**dadurch gekennzeichnet,**
daß sämtliche Verbindungsschienen als niederinduktive Mehrlagen-Verbindungsschienen (51 bzw. 53) ausgebildet und jeweils in vertikaler Hochkantstellung angeordnet sind, wobei eine zentrale durchgehende Mehrlagen-Hauptverbindungsschiene (51), an der Plus-,Minus- und Null-Potential einer Gleichspannungsquelle anliegt, zwischen zwei nebeneinander liegenden Kühlkörpern (50) angeordnet ist und dabei die obere Montageebene (M) der Kühlkörper (50) überragt,
daß wenigstens 3 Mehrlagen-Nebenverbindungsschienen (53) vorgesehen sind, die, gleichartig gestaltet, die Mehrlagen-Hauptverbindungsschiene (51) rechtwinklig in Aussparungen (58) kreuzen und an die Mehrlagen-Hauptverbindungsschiene (51) elektrisch angeschlossen sind,
und daß die über die Mehrlagen-Verbindungsschienen (51,53) gebildeten Fächer in Richtung auf die obere Montageebene (M) der Kühlkörper (50) frei zugänglich sind für eine phasenweise gleichartige Anordnung und Montage der Halbleiterventile und weiteren Schaltungselemente auf der oberen Montageebene (M) der Kühlkörper (50) sowie für entsprechend gleichartige elektrische Anschlüsse an den Leitern der Mehrlagen-Nebenverbindungsschienen (53).

2. Aufbau eines Wechselrichters nach Anspruch 1,
**dadurch gekennzeichnet**,
daß jeweils zwei beiderseits der Mehrlagen-Hauptverbindungsschiene (51) angrenzende Fächer ein Paar bilden, in denen die Halbleiterventile (z.B. 5,6 /7,8, bzw. 52) und weiteren Schaltungselemente (z.B. 3/4 bzw. 56) einer Phase (z.B. R) untergebracht und angeschlossen sind.

3. Aufbau eines Wechselrichters nach Anspruch 1 oder 2,
**dadurch gekennzeichnet**,
daß die Halbleiterventile (z.B. 5,6 /7,8, bzw. 52) und weiteren Schaltungselemente (z.B. 3/4 bzw. 56) einer Phase mittels darüber befindlicher Laschen (54,55) an einer zugeordneten Mehrlagen-Nebenverbindungsschiene (53) elektrisch angeschlossen sind.

4. Aufbau eines Wechselrichters nach einem der Ansprüche 1 bis 3,
**dadurch gekennzeichnet**,
daß die Leiter der Mehrlagen-Nebenverbindungsschienen (53) über abgewinkelte Anschlußlaschen an den Anschlußstellen (A,B,C) mit den zugeordneten Leitern gleichen Potentials der Mehrlagen-Hauptverbindungsschiene (51) verschraubt sind.

5. Aufbau eines Wechselrichters nach einem der Ansprüche 1 bis 4,
**dadurch gekennzeichnet**,
daß die Netzkondensatoren (1,2) auf der der Montageseite (M) abgewandten Kühlrippenseite beider Kühlkörper (50) untergebracht sind, wo sie liegend einander mit den Anschlußseiten zugewandt mit Anschlußlaschen der zentralen durchgehenden Mehrlagen-Hauptverbindungsschiene (51) verbunden sind.

6. Aufbau eines Wechselrichters nach Anspruch 5,
**dadurch gekennzeichnet**,
daß insbesondere für einen 3-Punktwechselrichter die Netzkondensatoren (1,2) aus zwei Gruppen (1', 2') bestehen, die mit der Mehrlagen-Hauptverbindungsschiene (51) verbunden sind.

7. Aufbau eines Wechselrichters nach einem der vorhergehenden Ansprüche,
**dadurch gekennzeichnet**,
daß die Kühlkörper (50) die Deckplatte eines Gehäuses bilden, in dem die Kühlrippen in einen von einem Kühlmedium durchströmten Kühlkanal liegen.

## Claims

1. Build-up of an inverter, in particular a 3-point inverter, in which the required semiconductor valves and further circuit elements are accommodated on cooling bodies and a build-up, which is alike in electrical and mechanical aspects, is achievable by several mutually crossing connecting rails with a compartmental division, in which the semiconductor valves and further circuit elements are connectable combined phase by phase to the connecting rails, characterised thereby, that all connecting rails are constructed as low-inductance multilayer connecting rails (51 or 53) and each arranged in vertical upright setting, wherein a central continuous multilayer main connecting rail (51), at which positive, negative and zero potential of a direct voltage source is present, is arranged between two cooling bodies (50) lying one beside the other and in that case projects beyond the upper assembly plane (M) of the cooling bodies (50), that at least 3 multilayer auxiliary connecting rails (53) are provided, which constructed in like manner cross the multilayer main connecting rail (51) at right angles in recesses (58) and are electrically connected to the multilayer main connecting rail (51) and that the compartments, which are formed by way of the multilayer auxiliary connecting rails (51, 53) are freely accessible in the direction towards the upper assembly plane (M) of the cooling bodies (50) for an arrangement and assembly, alike phase by phase, of the semiconductor valves and further circuit elements on the upper assembly plane (M) of the cooling bodies (50) as well as for correspondingly alike electrical connections at the conductors of the multilayer auxiliary connecting rails (53).

2. Build-up of an inverter according to claim 1, characterised thereby, that each two compartments adjoining the multilayer main connecting rail (51) at both sides form a pair, in which the semiconductor valves (for example 5, 6/7, 8 or 52) and further circuit elements (for example 3/4 or 56) of one phase (for example R) are accommodated and connected.

3. Build-up of an inverter according to claim 1 or 2, characterised thereby, that the semiconductor valves (for example 5, 6/7, 8 or 52) and further circuit elements (for example 3/4 or 56) of one phase are electrically connected by means of straps (54, 55) arranged thereover to an associated multilayer auxiliary connecting rail (53).

4. Build-up of an inverter according to one of the claims 1 to 3, characterised thereby, that the conductors of the multilayer auxiliary connecting rails (53) are screw-fastened by way of bent-over connecting straps at the connecting places (A, B, C) to the associated conductors of like potential of the multilayer main connecting rail (51).

5. Build-up of an inverter according to one of the claims 1 to 4, characterised thereby, that the mains capacitors (1, 2) are accommodated on that cooling rib side of both the cooling bodies (50), which is remote from the assembly side (M), where they lie one against the other facing by the connection sides and are connected with the connecting straps of the central continuous multilayer main connecting rail (51).

6. Build-up of an inverter according to claim 5, characterised thereby, that in particular for 3-point inverter, the mains capacitors (1, 2) consist of the groups (1', 2'), which are connected with the multilayer main connecting rail (51).

7. Build-up of an inverter according to one of the preceding claims, characterised thereby, that the cooling bodies (50) form the cover plate of a housing, in which the cooling ribs lie in a cooling channel flowed through by a cooling medium.

## Revendications

1. Structure d'un onduleur, en particulier d'un onduleur à trois points, dans lequel les diodes semiconductrices nécessaires et autres éléments de circuit sont disposés sur des radiateurs et avec plusieurs rails de liaison se croisant, une structure identique du point de vue électrique et mécanique peut être obtenue avec une répartition en forme de compartiments, dans lequel les diodes semiconductrices et autres éléments de circuit de l'onduleur peuvent être reliés, réunis par phase, aux rails de liaison, caractérisée en ce que l'ensemble des rails de liaison sont réalisés sous la forme de rails de liaison à plusieurs couches simplement inductifs (51, respectivement 53) et sont disposés en position de chant verticale, un rail de liaison principal à plusieurs couches continu central (51) auquel est appliqué le potentiel plus, moins et nul d'une source de tension continue, est disposé entre deux radiateurs juxtaposés (50) et dans lequel déborde le plan de montage supérieur (M) des radiateurs (50),
en ce qu'au moins trois rails de liaison auxiliaires à plusieurs couches (53) sont prévus, qui, de structure identique, croisent à angle droit dans des évidements (58) les rails de liaison principaux à plusieurs couches (51) et sont reliés électriquement au rail de liaison principal à plusieurs couches (51),
et en ce que les compartiments formés au-dessus des rails de liaison à plusieurs couches (51, 53) sont librement accessibles en direction du plan de montage supérieur (M) des radiateurs (50) pour une disposition et un montage identique par phase des diodes semiconductrices et autres éléments de circuit sur le plan de montage supérieur (M) des radiateurs (50) ainsi que pour des raccordements électriques identiques correspondant aux conducteurs des rails de liaison auxiliaires à plusieurs couches (53).

2. Structure d'un onduleur selon la revendication 1, caractérisée en ce que deux compartiments adjacents de part et d'autre au rail de liaison principal à plusieurs couches (31) forment une paire, dans lesquels les diodes semiconductrices (par exemple 5, 6 / 7,8, respectivement, 52) et autres éléments de circuit (par exemple 3/4, respectivement 56) sont disposés et reliés à une phase (R).

3. Structure d'un onduleur selon la revendication 1 ou 2, caractérisée en ce que les diodes semiconductrices (5, 6 / 7,8, respectivement 52) et autres éléments de circuit (par exemple 3/4, respectivement 56) d'une phase sont reliés électriquement au moyen d'attaches (54, 55) se trouvant au-dessus à un rail de liaison auxiliaire à plusieurs couches associé (53).

4. Structure d'un onduleur selon l'une des revendications 1 à 3, caractérisée en ce que les conducteurs des rails de liaison auxiliaires à plusieurs couches (53) sont vissés par l'intermédiaire d'attaches de raccordement pliées aux points de raccordement (A, B, C) aux conducteurs associés de même potentiel du rail de liaison principal à plusieurs couches (51).

5. Structure d'un onduleur selon les revendications 1 à 4, caractérisée en ce que les condensateurs de réseau (1, 2) sont disposés sur le côté des nervures de refroidissement éloignées au côté montage (M) des deux radiateurs (50), où ils sont reliés se trouvant l'un dans l'autre aux côtés de raccordement tournés vers les attaches de raccordement du rail de liaison principal à plusieurs couches continu central (51).

6. Structure d'un onduleur selon la revendication 5, caractérisée en ce que, en particulier, pour un onduleur à trois points, les condensateurs de réseau (1, 2) se composent de deux groupes (1', 2'), qui sont reliés au rail de liaison principal à plusieurs couches (51).

7. Structure d'un onduleur selon l'une des revendications précédentes, caractérisée en ce que les radiateurs (50) forment la plaque de recouvrement d'un boîtier, dans lequel les nervures de refroidissement se trouvent dans un canal de refroidissement parcouru par un fluide de refroidissement.
